(19) Europäisches Patentamt
European Patent Office
Office européen des brevets

(11) **EP 2 366 469 A1**

(12) **EUROPEAN PATENT APPLICATION**
published in accordance with Art. 153(4) EPC

(43) Date of publication:
**21.09.2011 Bulletin 2011/38**

(51) Int Cl.:
**B21C 47/24** (2006.01)　　**B21C 47/26** (2006.01)
**B65H 18/28** (2006.01)

(21) Application number: **09828985.3**

(22) Date of filing: **13.11.2009**

(86) International application number:
**PCT/JP2009/069346**

(87) International publication number:
**WO 2010/061737 (03.06.2010 Gazette 2010/22)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **25.11.2008　JP 2008299446**

(71) Applicant: **JX Nippon Mining & Metals Corporation Tokyo 100-8164 (JP)**

(72) Inventor: **HANAFUSA, Mikio**
**Hitachi-city**
**Ibaraki 317-0056 (JP)**

(74) Representative: **Hoarton, Lloyd Douglas Charles**
**Forrester & Boehmert**
**Pettenkoferstrasse 20-22**
**80336 Munich (DE)**

(54) **METHOD OF WINDING UP COPPER FOIL OR COPPER-CLAD LAMINATE**

(57)　Two pieces of narrow double-sided adhesive tapes each having a length that is equal to or slightly longer than the width of a material to be wound up and one piece of a wide adhesive backup tape having a length that is longer than the width of the foregoing double-sided adhesive tape and the material to be wound up are prepared in a method of winding up the material to be wound up. The first and second double-sided adhesive tapes are affixed, parallel to the axis of a core tube, onto a surface of the core tube with a gap provided therebetween. Subsequently, the material to be wound up is affixed with the first double-sided adhesive tape as the starting end, the core tube is rotated, and, upon reaching a position where the second double-sided adhesive tape is present, the material to be wound is affixed to the second double-sided adhesive tape. After the wide adhesive backup tape having a length that is longer than the width of the material to be wound is affixed to the core tube on top of the first and second double-sided adhesive tapes and the material to be wound up wrapped therearound, the winding-up operation is continued. Consequently, the occurrence of wrinkles and baggies can be inhibited during the winding-up operation and the winding collapse can be prevented by increasing the winding tension.

Fig. 1

EP 2 366 469 A1

**Description**

TECHNICAL FIELD

The present invention relates to a method of winding a copper foil or a copper-clad laminate around a core.

BACKGROUND ART

A' FCCL' ( a flexible copper-clad laminate) obtained by laminating a copper foil onto a resin film such as a polyamide film is being broadly used as a material of a circuit board in the electronics industry. A copper foil can be classified into a rolled copper foil and an electrolytic copper foil, and these are respectively wound around a core tube, also referred to as a "core roll". A metal-coated polyamide complex is manufactured by unwinding the foregoing copper foil and bonding it to a resin film such as a polyamide film.

Upon starting the foregoing winding-up process, there are two ways conventionally: an adhesive is applied to the core tube or a double-sided adhesive tape with release paper is used to perform the winding-up process. A typical example is described in Patent Document 1.

In Patent Document 1, the copper foil is wound around the core tube by using a double-sided adhesive tape with release paper, and fixes the copper foil by using two pieces of double-sided adhesive tape with release paper with a wind-up method to achieve a wound roll.

These methods of using an adhesive tape or applying an adhesive on the winding core tube entail major problems. Specifically, unevenness or a convex shape occurs at the starting end of the winding, whereby wrinkles and baggies are formed.

This kind of unevenness occurs when the copper foil is not to be affixed properly or not to be cut sharply, but it can be said that it is unavoidable since there will always be a starting end of the copper foil to be wound up.

The problem here is that an adhesive is added to the copper foil, and the thickness of the starting end increases thereby. The winding-up process being repeated, unevenness will always occur at the portion of the starting end where an adhesive has been added. While improvement in adhesion to increase the winding strength is important in a sense, a copper foil with such unevenness is undesirable.

Moreover, in order to reduce the foregoing wrinkles and baggies, it is necessary to reduce the winding tension. Nevertheless, if the winding tension is low, there is a problem in that the wound copper foil, at the time of reusing the same, will have a winding collapse upon unwinding, referred to as "winding off',.

As the winding diameter increases, the influence of the unevenness will decrease, but at the stage where the winding diameter is small, deterioration in the quality of the copper foil due to such unevenness cannot be ignored, and the copper foil of such portion cannot be used as a product. Accordingly, these circumstances considerably deteriorate the production yield.

[Patent Document 1] Japanese Patent No. 3565424

DISCLOSURE OF THE INVENTION

The present invention was devised in view of the foregoing problems. Thus, an object of this invention is to provide a method of winding up a copper foil or a copper-clad laminate capable of inhibiting the occurrence of wrinkles and baggies during the winding-up operation and preventing the winding collapse by increasing the winding tension.

In light of the above, the present invention provides:

1. A method of winding up a copper foil or a copper-clad laminate, wherein, upon winding a copper foil or a copper-clad laminate around a core tube, two pieces of narrow double-sided adhesive tapes each having a length that is equal to or slightly longer than the width of the copper foil or the copper-clad laminate and one piece of a wide adhesive backup tape having a length that is longer than the width of the double-sided adhesive tape and the copper foil or the copper-clad laminate are prepared, the first and second double-sided adhesive tapes are affixed, parallel to an axis of a core tube, onto a surface of the core tube with a gap provided therebetween, subsequently the copper foil or the copper-clad laminate is affixed with the first double-sided adhesive tape as a starting end, the core tube is rotated so that the copper foil or the copper-clad laminate is rotated in a direction that is opposite to a direction where the adjacent second double-sided adhesive tape is present, and, upon reaching a position where the second double-sided adhesive tape is present, the copper foil or the copper-clad laminate is affixed to the second double-sided adhesive tape, the rotation of the core tube is stopped at this point, and, after the wide adhesive backup tape having a length that is longer than the width of the copper foil or the copper-clad laminate is affixed to the core tube on top of the first and second double-sided adhesive tapes and the copper foil or the copper-clad laminate wrapped therearound, the winding-up operation is continued;

2. The method of winding up a copper foil or a copper-clad laminate according to paragraph 1 above, wherein the width of the double-sided adhesive tape is 10 to 50 mm;

3. The method of winding up a copper foil or a copper-clad laminate according to paragraph 1 or paragraph 2 above, wherein the gap between the first and second double-sided adhesive tapes is 0.1 to 30 mm;

4. The method of winding up a copper foil or a copper-clad laminate according to any one of paragraphs 1 to 3 above, wherein the width of the wide adhesive backup tape is 25 to 150 mm;

5. The method of winding up a copper foil or a copper-clad laminate according to any one of paragraphs 1 to 4 above, wherein used is an adhesive backup tape having a length in which the length of the wide adhesive backup tape protrudes 25 to 500 mm from each of either ends of the copper foil or the copper-clad laminate; and

6. The method of winding up a copper foil or a copper-clad laminate according to any one of paragraphs 1 to 5 above, wherein a double-sided adhesive tape with release paper is used, and the double-sided adhesive tape with release paper is affixed to the core tube in advance prior to starting the winding-operation.

[Effect of the Invention]

The present invention yields a superior effect of being able to increase the production yield and improve the productivity by inhibiting the occurrence of wrinkles and baggies during the winding-up operation and preventing the winding collapse by increasing the winding tension.

BRIEF DESCRIPTION OF THE DRAWINGS

Fig. 1 is a schematic explanatory diagram of the initial state upon starting the winding of the copper foil around the core tube.
Fig. 2 is a cross section explanatory diagram showing a state where the copper foil is affixed to the first tape of the double-sided adhesive tapes which has been affixed to the core tube, and the winding-up process is started.
Fig. 3 is a cross section explanatory diagram showing a state where the winding-up process is started, and, at the point where the copper foil makes a full circle around the core tube, the copper foil is affixed to the second tape of the double-sided adhesive tapes.
Fig. 4 is a cross section explanatory diagram showing a state where the winding-up process is started, and, at the point where the copper foil makes a full circle around the core tube, the backup tape is additionally affixed on top of the copper foil which has been affixed to the second tape of the double-sided adhesive tapes.

BEST MODE FOR CARRYING OUT THE INVENTION

A typical example of the present invention is now explained with reference to the appended drawings. Note that the following explanation shows a preferred mode of the invention, and the present invention is not limited thereby. Accordingly, the modifications and other examples and modes included in the technical concept of the invention described in the ensuing claims and this specification are all covered by the present invention.
Note that the present invention can be applied to a copper foil and a copper-clad laminate, and the following example is explained using copper foil as the typical example. Needless to say, it should be easy to understand that the present invention can be also applied to a copper-clad laminate by replacing the term "copper foil" with "copper-clad laminate" in the example explained below.

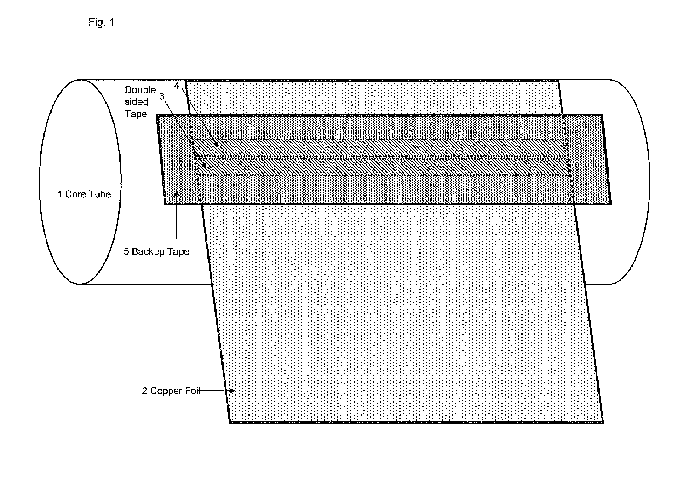

Fig. 1 is a schematic explanatory diagram of the initial state upon starting the winding of the copper foil around the core tube. Fig. 1 shows the state of winding a copper foil 2 around a wind-up core tube 1. The core tube 1 is generally made of ABS, roll formed by coating FRP with epoxy resin or NBR, or phenol resin, but it is not necessarily limited to the foregoing materials so as long as the surface has a certain level of wettability and is a material which does not allow the penetration of water, aqueous solution or organic solvent.
Upon winding the copper foil 2 around the core tube 1, two pieces of narrow double-sided adhesive tapes 3 and 4 having a length equal to the width of the copper foil 2 and one wide adhesive backup tape 5 having a length that is longer than the width of the length are prepared.

There is no particular limitation on the size of the double-sided adhesive tapes 3 and 4, and the size can be changed according to the size of the copper foil 2 and the size of the core tube 1. The width of the double-sided adhesive tape is generally 10 to 50 mm.
As shown in Fig. 1, the first and second double-sided adhesive tapes 3 and 4 are affixed, parallel to an axis of the core tube, onto the surface of the core tube with a gap provided therebetween. The gap between the first and second double-sided adhesive tapes 3 and 4 is arbitrary, but is favorably set to be 0.1 to 30 mm in consideration of efficiency.

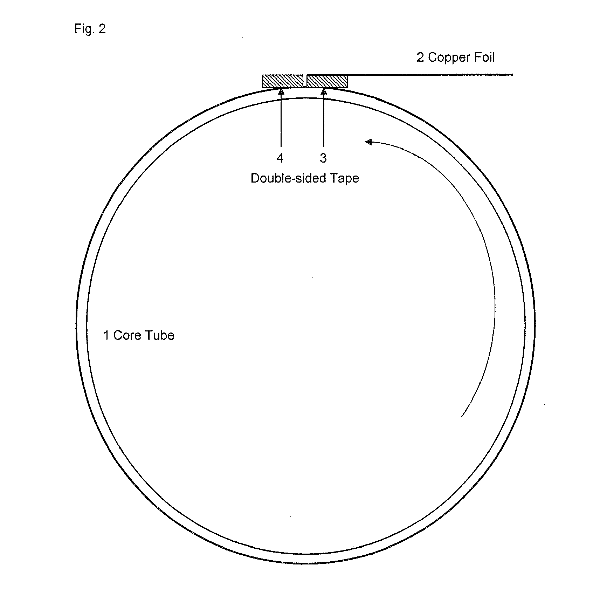

Next, as shown in Fig. 2, the copper foil 2 is affixed with the first double-sided adhesive tape 3 as the starting end, and the core tube 1 is rotated so that the copper foil 2 is rotated (makes a full circle) in a direction that is opposite to a direction where the adjacent second double-sided adhesive tape 4 is present.

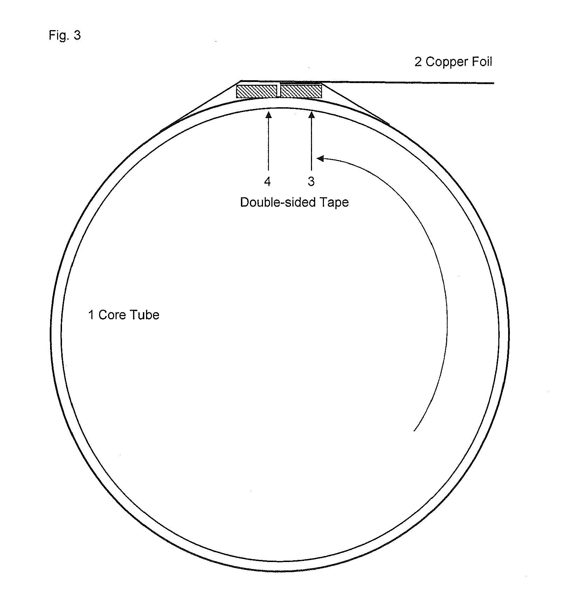

Upon reaching a position where the second double-sided adhesive tape 4 is present based on the foregoing rotation, as shown in Fig. 3, the copper foil 2 is affixed to the second double-sided adhesive tape 4. Simultaneously, the rotation of the core tube is stopped at this point.

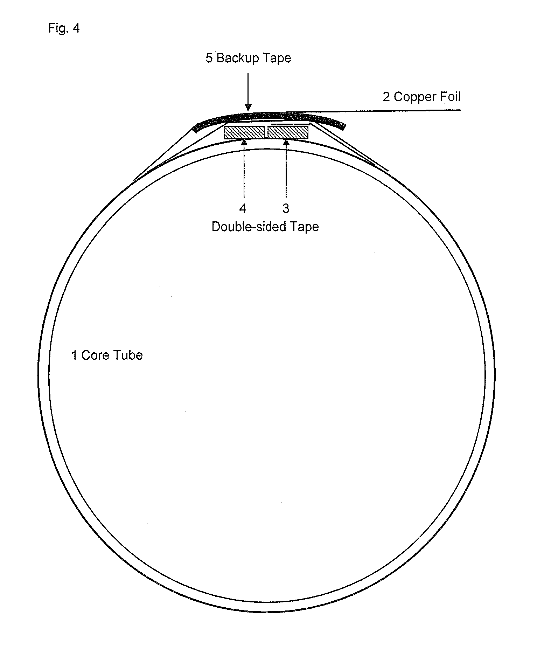

Subsequently, as shown in Fig. 4, the wide adhesive backup tape 5 having a length that is longer than the width of the copper foil 2 is affixed to the core tube 1 on top of the first and second double-sided adhesive tapes 3 and 4, and the copper foil 2 wrapped therearound. Subsequently, the winding-operation is continued. One surface (affixing surface) of the wide adhesive backup tape 5 possesses adhesiveness as a matter of course.

After affixing the wide adhesive backup tape 5, since the affixation strength will increase considerably, the winding tension can be increased. It is thereby possible to inhibit the generation of wrinkles and formation of convex portions. Moreover, since the unevenness arising from the narrow double-sided adhesive tapes 3 and 4 is planarized by the wide adhesive backup tape 5, there is an advantage in that the unevenness becomes unnoticeable.

The width of the wide adhesive backup tape 5 is desirably 25 to 150 mm. There is no particular limitation in the width of the wide adhesive backup tape 5 so long as it is longer than the width of the copper foil and greater than the total width obtained by adding the gap between the double-sided adhesive tapes 3 and 4 to the width of the double-sided adhesive tapes 3 and 4 as shown in Fig. 1. But a vinyl tape 5 having a width of 25 to 150 mm is normally used. This width can also be changed according to the size of the copper foil 2 to be wound and the size of the core tube 1.

With Patent Document 1 described above, the double-sided tape is affixed in a manner of being wider than the copper foil, and, after affixing the copper foil to the double-sided tape, and double-sided tape is removed. Upon the removal, there are cases that the copper foil is removed together or the incomplete removal causes the double-sided tape to remain. If the copper foil is accidentally removed, doing the winding operation all over again is necessary. Because by continuing to wind the copper foil up, wrinkles will occur from such spot. Meanwhile, if the double-sided tape remains, dirt will adhere to the tape and contaminate the copper foil.

Nevertheless, if a backup tape is used as with the present invention, it is no longer necessary to remove the double-sided tape, and a significant effect is yielded in that the adherence of dirt can also be prevented since the backup tape will cover the adhesive of the double-sided tape.

It is possible to use an adhesive backup tape having a length in which the length of the wide adhesive backup tape 5 protrudes 25 to 150 mm from each of either ends of the copper foil. It is also possible to use a double-sided adhesive tape with release paper, and affix the double-sided adhesive tape with release paper to the core tube in advance before starting the winding-operation. Consequently, there is an advantage in that the operation is not concentrated but rather simplified.

Thus, it is possible to prevent loosening or collapse of the winding. Even upon unreeling, " unwinding" in other words, it is possible to prevent the copper foil product from loosening or the collapse upon winding up the copper foil, and thus, the continuous use of the copper foil is achieved.

The Example and the Comparative Example are now explained.

(Example)

A copper foil having a thickness of 12 $\mu$m and a width of 1280 mm was wound around a core tube with an outer diameter of $\phi$ 110 mm and a length of 1380 mm.

Two pieces of double-sided adhesive tapes having a width of 15 mm and a length of 1285 mm which is longer than the width of the copper foil were prepared, and these were affixed to the core tube as shown in Fig. 1 and Fig. 2. The first and second double-sided adhesive tapes were affixed with a gap of 2 mm therebetween as shown in Fig. 1 and Fig. 2. A wide adhesive backup tape with a width of 50 mm and a length which protrudes 25 mm from each of either ends of the copper foil was prepared.

As shown in Fig. 3, the core tube was rotated so that the copper foil makes a full circle around the core tube, the copper foil was affixed to the double-sided tape at the position of the second double-sided adhesive tape, and the wide adhesive backup tape was further affixed thereon and fixed as shown in Fig. 1 and Fig. 4.

Subsequently, 700 to 900 m of the copper foil was wound at a tension of 27 kg and winding speed of 60 m/min. After the winding was started, the existence of defects such as wrinkles was confirmed at 5 m to 50 m, and, if a defect was discovered, the copper foil was once again affixed to the core.

The number of times that winding defects such as wrinkles had occurred and the length of the copper foil that was discarded in the foregoing process were recorded, and the rejection rate, product rate and winding deviation rate were obtained. The calculation method was as follows.

$$\text{Rejection rate} = \text{Number of times that defects occurred} / \text{number of product rolls} \times 100(\%)$$

$$\text{Product rate} = (\text{product length}) / (\text{product length} + \text{length of discarded copper foil}) \times 100(\%)$$

$$\text{Winding deviation rate} = \text{Number of rolls subject to winding deviation} / \text{number of product rolls} \times 100(\%)$$

The results are shown in Table 1.
[Table1]

|  | Rejection Rate (%) | Product Rate (%) | Winding Deviation Rate (%) |
|---|---|---|---|
| Example | 1.0 | 99.9 | 0.04 |
| Comparative Example | 11.5 | 99.3 | 0.12 |

As shown in Fig. 1, in the Example, the rejection rate was low at 1.0%, the product rate reached 99.9%, and the winding deviation rate was low at 0.04%. Favorable results were obtained compared to the Comparative Example described below.

(Comparative Example)

The results upon winding the copper foil without a backup tape are shown. The same conditions as the Example were used other than not using a backup tape.
Specifically, as shown in Fig. 3, the core tube was rotated so that the copper foil makes a full circle around the core tube, the copper foil was affixed to the double-sided tape at the position of the second double-sided adhesive tape, and the wide adhesive backup tape was additionally affixed thereon and fixed as shown in Fig. 1 and Fig. 4.
Subsequently, 700 to 900 m of the copper foil was wound at a tension of 27 kg and winding speed of 60 m/min. After starting the winding, the existence of defects such as wrinkles was examined at 5 m to 50 m. If a defect was discovered, the copper foil was once again affixed to the core.
Subsequently, as with the Example, the number of times that winding defects such as wrinkles had occurred and the length of the copper foil that was discarded in the foregoing process were recorded. And the rejection rate, product rate and winding deviation rate were obtained.
Consequently, as shown in Table 1, in the Comparative Example, the rejection rate increased to 11.5%, the product rate decreased to 99.3%, and the winding deviation rate increased to 0.12%.
The results of Comparative Example are clearly inferior to those of the Example, and this is a result of not using a backup tape. Accordingly, it was discovered that the presence the backup tape has many effects on the product though it is of a simple structure.

INDUSTRIAL APPLICABILITY

The present invention provides a method of being able to increase the production yield and improve the productivity by inhibiting the occurrence of wrinkles and baggies during the winding-up operation and preventing the winding collapse by increasing the winding tension. Consequently, the present invention yields a superior effect of being able to reduce the deterioration in the quality of the copper foil or the copper-clad laminate caused by the occurrence of unevenness during the winding-up process, enable the use of the copper foil of such portion as a product, and thereby increase the production yield and improve the productivity. There present invention is thus effective for use in a winding material of a copper foil or a copper-clad laminate that is used as a mounting material of electronic components such as a flexible substrate, TAB, COF (Chip on Film), and the like.

DISCRIPTION OF REFERENCE NUMERALS

1: core tube
2: copper foil
3: double-sided adhesive tape (first tape)
4: double-sided adhesive tape (second tape)
5: backup tape

**Claims**

1. A method of winding up a copper foil or a copper-clad laminate, wherein, upon winding a copper foil or a Copper-clad laminate around a core tube, two pieces of narrow double-sided adhesive tapes each having a length that is equal to or slightly longer than the width of the copper foil or the copper-clad laminate and one piece of a wide adhesive backup tape having a length that is longer than the width of the double-sided adhesive tape and the copper foil or the copper-clad laminate are prepared, the first and second double-sided adhesive tapes are affixed, parallel to an axis of a core tube, onto a surface of the core tube with a gap provided therebetween, subsequently the copper foil or the copper-clad laminate is affixed with the first double-sided adhesive tape as a starting end, the core tube is rotated so that the copper foil or the copper-clad laminate is rotated in a direction that is opposite to a direction where the adjacent second double-sided adhesive tape is present, and, upon reaching a position where the second double-sided adhesive tape is present, the copper foil or the copper-clad laminate is affixed to the second double-sided adhesive tape, the rotation of the core tube is stopped at this point, and, after the wide adhesive backup tape having a length that is longer than the width of the copper foil or the copper-clad laminate is affixed to the core tube on top of the first and second double-sided adhesive tapes and the copper foil or the copper-clad laminate wrapped therearound, the winding-up operation is continued.

2. The method of winding up a copper foil or a copper-clad laminate according to claim 1, wherein the width of the double-sided adhesive tape is 10 to 50 mm.

3. The method of winding up a copper foil or a copper-clad laminate according to claim 1 or claim 2, wherein the gap between the first and second double-sided adhesive tapes is 0.1 to 30 mm.

4. The method of winding up a copper foil or a copper-clad laminate according to any one of claims 1 to 3, wherein the width of the wide adhesive backup tape is 25 to 150 mm.

5. The method of winding up a copper foil or a copper-clad laminate according to any one of claims 1 to 4, wherein used is an adhesive backup tape having a length in which the length of the wide adhesive backup tape protrudes 25 to 150 mm from each of either ends of the copper foil or the copper-clad laminate.

6. The method of winding up a copper foil or a copper-clad laminate according to any one of claims 1 to 5, wherein a double-sided adhesive tape with release paper is used, and the double-sided adhesive tape with release paper is affixed to the core tube in advance prior to starting the winding-operation.

Fig. 1

Double sided Tape

4

3

1 Core Tube

5 Backup Tape

2 Copper Foil

Fig. 2

2 Copper Foil

4   3
Double-sided Tape

1 Core Tube

Fig. 3

2 Copper Foil

4 3
Double-sided Tape

1 Core Tube

Fig. 4

5 Backup Tape

2 Copper Foil

4     3
Double-sided Tape

1 Core Tube

## INTERNATIONAL SEARCH REPORT

| International application No. |
|---|
| PCT/JP2009/069346 |

A. CLASSIFICATION OF SUBJECT MATTER
*B21C47/24*(2006.01)i, *B21C47/26*(2006.01)i, *B65H18/28*(2006.01)i

According to International Patent Classification (IPC) or to both national classification and IPC

B. FIELDS SEARCHED

Minimum documentation searched (classification system followed by classification symbols)
B21C47/24, B21C47/26, B65H18/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 3565424 B2   (Mitsui Mining & Smelting Co., Ltd.), 15 September 2004 (15.09.2004), claims & US 2002/0027179 A1    & WO 2002/005980 A1 & TW 532053 B              & CN 1386075 A | 1-6 |
| A | JP 11-19722 A   (Sumitomo Metal Industries, Ltd.), 26 January 1999 (26.01.1999), entire text (Family: none) | 1-6 |
| A | JP 11-33626 A   (Nippon Light Metal Co., Ltd.), 09 February 1999 (09.02.1999), entire text (Family: none) | 1-6 |

☐ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 December, 2009 (09.12.09) | 22 December, 2009 (22.12.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**EP 2 366 469 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3565424 B